(19) Europäisches Patentamt
European Patent Office
Office européen des brevets

(11) **EP 1 936 389 B1**

(12) **FASCICULE DE BREVET EUROPEEN**

(45) Date de publication et mention
de la délivrance du brevet:
**18.11.2009 Bulletin 2009/47**

(51) Int Cl.:
***G01R 15/18*** *(2006.01)*

(21) Numéro de dépôt: **07150185.2**

(22) Date de dépôt: **20.12.2007**

(54) **Capteur inductif de mesure de courant**

Induktiver Stromsensor

Inductive current sensor

(84) Etats contractants désignés:
**AT BE BG CH CY CZ DE DK EE ES FI FR GB GR
HU IE IS IT LI LT LU LV MC MT NL PL PT RO SE
SI SK TR**

(30) Priorité: **22.12.2006 FR 0655887**

(43) Date de publication de la demande:
**25.06.2008 Bulletin 2008/26**

(73) Titulaire: **Actaris SAS
92100 Boulogne Billancourt (FR)**

(72) Inventeurs:
• **Tissier, Jean-François
86360, CHASSENEUIL DU POITOU (FR)**
• **Fichen, Yvon
75014, PARIS (FR)**
• **Rowe, Malcolm
Ipswich, IP4 5RQ (GB)**

(74) Mandataire: **Hervouet, Sylvie
Feray Lenne Conseil
39/41, avenue Aristide Briand
92163 Anthony Cedex (FR)**

(56) Documents cités:
**EP-A- 1 515 146     WO-A-01/86670
WO-A-02/066996     DE-A1- 10 110 254
GB-A- 2 353 099**

**Description**

La présente invention concerne un capteur de mesure de courant alternatif de type inductif.

Les capteurs de mesure de courant alternatif sont classiquement utilisés dans les compteurs de consommation électrique à usage industriel ou résidentiel. Plus précisément, un capteur est associé à chaque phase du compteur. Ainsi, dans le cas d'un compteur monophasé, un seul capteur est utilisé, alors que dans le cas d'un compteur triphasé, trois capteurs de mesure sont utilisés pour permettre la mesure du courant dans chaque phase.

De tels capteurs sont de réalisation difficile car ils requièrent une grande immunité aux contraintes d'environnement, qu'elles soient de type thermodynamique (température, pression, humidité) ou électromagnétique (champs électriques et magnétiques).

Le capteur de mesure de courant doit en outre avoir une linéarité et une précision sur une large dynamique de courant et sur une large bande passante fréquentielle, l'onde de courant mesurée pouvant contenir de nombreux rangs harmoniques.

Aujourd'hui, les solutions classiques pour de tels capteurs peuvent être regroupées en quatre grandes familles :

- les capteurs passifs de type résistif (shunt),
- les transformateurs de courant à noyau magnétique,
- les capteurs inductifs,
- les capteurs actifs de type à Effet Hall, ou capteurs de champ magnétique.

Le principe physique utilisé par le capteur de courant conditionne son immunité aux paramètres d'environnement, et détermine notamment les moyens de fraude qui peuvent être appliqués au compteur pour falsifier la mesure de courant, et par suite, la comptabilisation de l'énergie électrique consommée.

Par exemple, un capteur résistif de type shunt, basé sur la loi d'Ohm, est insensible par principe aux champs magnétiques continus, et faiblement sensible aux champs magnétiques alternatifs. Par contre, il présente une mauvaise stabilité en température.

Un capteur inductif, qui possède un blindage de forte perméabilité magnétique, aura quant à lui une très bonne immunité aux champs magnétiques alternatifs externes et, dans le cas d'un compteur électrique multi phases nécessitant un capteur par phase, une très bonne réjection des influences magnétiques interphases internes au compteur. En revanche, un tel capteur inductif aura une faible immunité aux champs magnétiques continus, notamment ceux qui sont produits par des aimants permanents de forte puissance.

Le capteur de mesure de courant de type inductif, basé sur un couplage magnétique dans l'air entre un circuit primaire qui est une phase du réseau sur lequel est placé le compteur d'électricité et un circuit secondaire galvaniquement isolé du circuit primaire, représente cependant le meilleur compromis technique et économique, et l'on s'intéressera dans la suite uniquement à ce type de capteur.

Aujourd'hui, il existe principalement trois sous-familles de capteurs de courant de type inductif:

Dans une première sous-famille, les circuits primaire et secondaire sont réalisés par des pièces électromécaniques assemblées. On connaît notamment du document FR 2803914 un capteur comportant un conducteur primaire linéaire en cuivre en forme de U, destiné à porter le courant alternatif à mesurer, ainsi qu'un bobinage disposé à l'intérieur du U, formant circuit secondaire. Un élément de blindage en matériau à forte perméabilité magnétique (de type alliage fer-nickel, à forte teneur en nickel) entoure l'ensemble. La fonction de cet élément de blindage est double : Il s'agit, d'une part, d'emprisonner au sein du capteur le champ magnétique généré par le courant circulant dans le circuit primaire, et d'autre part, d'obtenir un capteur qui soit insensible aux champs magnétiques alternatifs extérieurs.

L'inconvénient principal d'un tel capteur réside dans l'existence même de l'élément de blindage qui utilise un matériau coûteux. Des essais ont été menés pour tenter de réduire l'épaisseur du blindage, mais cela se fait au détriment des performances de ce blindage. En outre, un tel élément de blindage peut être aisément saturé par l'utilisation frauduleuse d'un aimant permanent, conduisant à une mesure erronée du courant.

Dans une seconde sous-famille, le circuit secondaire du capteur de mesure de courant est réalisé par une ou plusieurs bobines planar sur circuit imprimé. Il n'est plus nécessaire ici d'utiliser d'éléments ferromagnétiques ou de blindages en matériau à forte perméabilité magnétique. Néanmoins, ce type de capteur a une faible sensibilité (inférieure à 100$\mu$V/A à 50Hz) qui résulte de la faible section totale de la bobine secondaire assurant la fonction de captation du flux magnétique primaire, cette faible sensibilité entraînant de fortes contraintes pour l'électronique de conditionnement et de traitement des signaux issus des capteurs. Ce type de capteur possède une sensibilité aux champs magnétiques alternatifs externes, ainsi qu'une sensibilité à la présence de masses ferromagnétiques dans l'environnement proche du capteur.

Dans une troisième sous-famille, le circuit secondaire du capteur de mesure de courant réalise une bobine Rogowski. Son principe est de réaliser une bobine sans noyau magnétique, fermée autour du conducteur primaire. Cette bobine a une densité de spires constante par unité d'angle. La section de ces spires est également parfaitement constante sur tout le bobinage. Ce type de capteur, tout comme ceux de la seconde sous famille est naturellement immune vis à vis des champs magnétiques continus, il a également une faible sensibilité (inférieure à 500µV/A à 50Hz) ; son point faible tient dans la difficulté de réalisation d'une bobine ayant une densité angulaire de spires constante et élevée tout en maîtrisant la section moyenne de ces spires tout au long de la bobine.

L'on s'intéressera dans ce qui suit uniquement au capteur de la première sous famille (pièces électromécaniques).

Au vu de ce qui précède, le but principal de la présente invention est de proposer un capteur inductif de mesure de courant ne nécessitant plus d'élément de blindage, tout en offrant la double fonction précédente, à savoir une très bonne concentration des lignes de champ magnétique induit par le circuit primaire à l'intérieur du capteur, et une bonne immunité aux champs magnétiques alternatifs extérieurs.

On connaît déjà du document EP 1 515 146 un capteur inductif de mesure de courant du type comportant un circuit primaire destiné à être parcouru par un courant alternatif à mesurer, et un circuit secondaire couplé magnétiquement dans l'air au circuit primaire, dans lequel le circuit primaire comporte deux groupes comportant chacun $2^P$ spires coaxiales selon un axe, p étant un entier supérieur ou égal à zéro, les deux groupes étant placés à égale distance de part et d'autre d'un point dudit axe constituant le centre du circuit primaire, de sorte que deux spires prises dans chacun des groupes, et placées de façon symétrique par rapport au centre du circuit primaire soient destinées à être parcourues par un courant de même intensité mais de sens opposé, correspondant au courant alternatif à mesurer ou à une portion du courant alternatif à mesurer, et le circuit secondaire comporte au moins deux bobines multi spires connectées en série, les deux bobines étant coaxiales et disposées le long dudit axe symétriquement par rapport audit centre du circuit primaire de sorte que chacune des deux bobines se retrouve à l'intérieur de l'un des deux groupes, chaque bobine possédant des spires enroulées dans un sens opposé par rapport aux spires de l'autre bobine.

La présente invention a pour objet un capteur inductif selon la revendication 1. Il est caractérisé en ce que chacun des deux groupes du circuit primaire comporte deux spires coaxiales selon ledit axe, chacune des deux spires étant destinée à être parcourue par une portion du courant alternatif à mesurer complémentaire de la portion du courant alternatif dans l'autre spire.

Grâce à cette géométrie particulière des circuits primaire et secondaire, et à leur agencement relatif, la composante du champ magnétique sur l'axe de symétrie des circuits primaire et secondaire, générée par le courant circulant dans le circuit primaire est prédominante dans deux zones de l'espace symétriques par rapport au centre du circuit primaire, zones dans lesquelles se trouve chacune des bobines du circuit secondaire, alors qu'il décroît très rapidement à l'extérieur du capteur. En outre, on peut démontrer qu'avec une telle géométrie du circuit primaire, la composante du champ magnétique est une fonction impaire par rapport à un système d'axe dont l'origine est le centre du capteur. Ainsi, les deux bobines du circuit secondaire génèrent une tension identique en amplitude, mais opposée en phase. En conséquence, ceci permet d'éliminer les tensions induites par un champ magnétique alternatif constant.

Enfin, en supprimant l'élément de blindage, on évite un autre inconvénient intrinsèque à cet élément, à savoir sa faible immunité au champ magnétique continu, généré par exemple par un aimant permanent.

Le circuit secondaire peut comporter deux groupements identiques comportant chacun deux bobines multi spires coaxiales disposées le long dudit axe, les deux groupements étant disposés symétriquement par rapport audit centre et connectés en série, les deux bobines d'un même groupement étant connectées en série mais présentant des spires enroulées dans des sens opposés, les gains et les positions selon l'axe des bobines d'un même groupement étant déterminés pour compenser l'influence d'un champ magnétique alternatif externe à gradient linéaire sur toute la longueur du circuit secondaire.

En variante, le circuit secondaire peut comporter deux groupements identiques comportant chacun trois bobines multi spires coaxiales disposées le long dudit axe, les deux groupements étant disposés symétriquement par rapport audit centre et connectés en série, les trois bobines d'un même groupement étant connectées en série mais présentant des spires enroulées dans des sens opposés, les gains et les positions selon l'axe des bobines d'un même groupement étant déterminés pour compenser l'influence d'un champ magnétique alternatif externe à gradient linéaire sur une longueur correspondant à la longueur de chaque groupement du circuit secondaire.

En généralisant le principe de la variante précédente, on peut avantageusement prévoir que le circuit secondaire comporte deux groupements identiques comportant chacun au moins un sous-groupement de trois bobines multi spires coaxiales disposées le long dudit axe, les deux groupements étant disposés symétriquement par rapport audit centre et connectés en série, les trois bobines d'un même sous-groupement étant connectées en série mais présentant des spires enroulées dans des sens opposés, les gains et les positions selon l'axe des bobines d'un même sous-groupement étant déterminés pour compenser l'influence d'un champ magnétique alternatif externe à gradient linéaire sur une longueur correspondant à la longueur de chaque sous-groupement du circuit secondaire.

De manière avantageuse, les deux bobines ou les deux groupements du circuit secondaire sont connectés, au niveau du centre du circuit primaire, à un même potentiel de référence. Grâce à cette disposition particulière, il est possible d'appliquer un traitement différentiel des tensions obtenues sur chacune des deux bobines, ou sur chacun des deux groupements, ce qui permet d'éliminer les signaux de mode commun, notamment les tensions dues au couplage électrostatique entre primaire et secondaire.

L'invention et les avantages qu'elle procure seront mieux compris au vu de la description suivante, faite en référence aux figures annexées dans lesquelles :

- les figures 1 a à 1c illustrent schématiquement plusieurs cas d'assemblages de spires formant des multi pôles magnétiques;
- les figures 2a et 2b représentent différentes courbes de variations du champ magnétique selon l'axe des spires pour les cas des figures 1 a à 1 c;
- les figures 3 et 4 illustrent en perspective un circuit primaire et un circuit secondaire d'un premier capteur, respectivement en vue éclatée et en vue assemblée;
- les figures 5a et 5b illustrent des vues en plan respectivement des circuits primaire et secondaire du capteur des figures 3 et 4;
- la figure 6 illustre une vue de face partielle d'un compteur électrique muni de trois capteurs identiques;
- la figure 7 est une variante du circuit primaire du premier capteur;
- la figure 8a est une première variante du circuit secondaire du premier capteur;
- la figure 8b est une deuxième variante du circuit secondaire du premier capteur ;
- les figures 9a et 9b illustrent, respectivement en perspective et en vue développée de dessus, un circuit primaire d'un second capteur;
- les figures 10a et 10b illustrent, respectivement en vue développée de dessus et en perspective, un circuit primaire d'un capteur selon un mode de réalisation possible conforme à l'invention;
- la figure 11 représente différentes courbes de variations du champ magnétique selon l'axe des spires obtenues avec le circuit primaire selon la figure 10b.

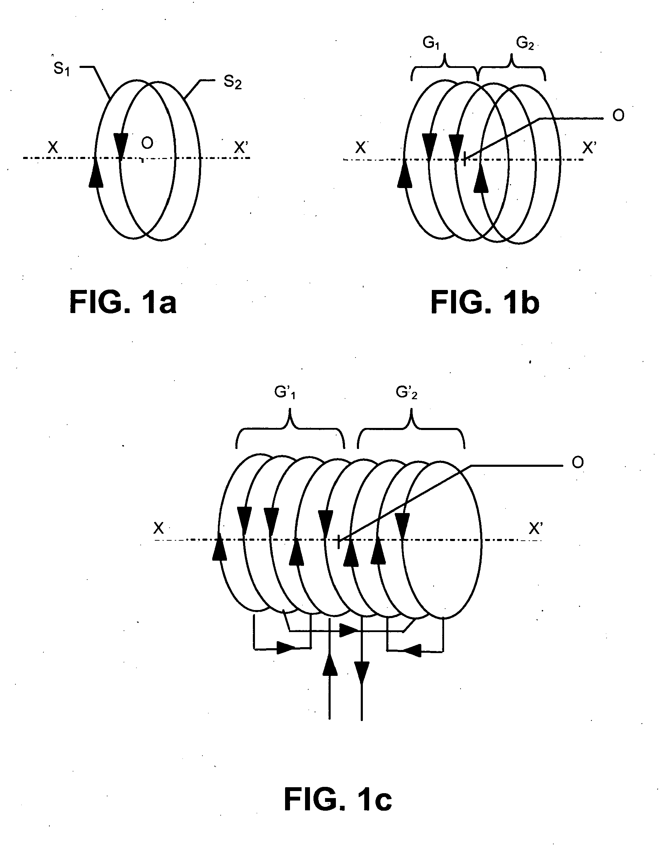

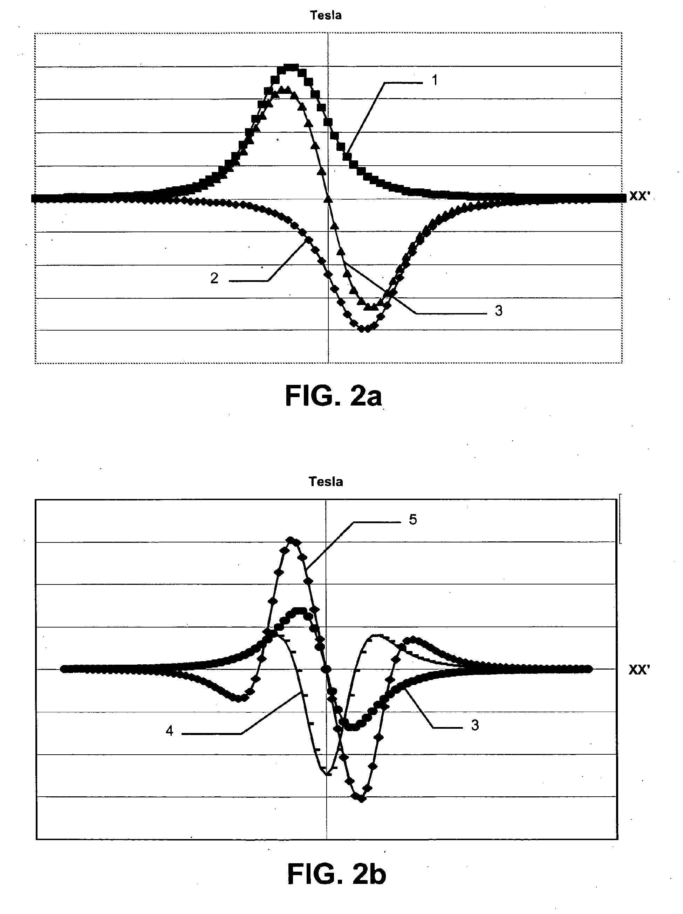

En se référant tout d'abord d'une part, aux figures 1 a à 1 c, et d'autre part, aux figures 2a et 2b, on décrit ci-après les principes d'électromagnétisme sur lesquels se fonde la présente invention.

Une spire circulaire parcourue par un courant est équivalente à un dipôle magnétique. Il en résulte qu'à l'extérieur de la spire et à distance de ce dipôle magnétique, l'amplitude du champ magnétique décroît en $1/x^3$, x étant l'abscisse d'un point de l'espace rapporté à un référentiel orthogonal passant par le centre de la spire et utilisant l'axe de la spire comme axe horizontal. Dans ce même référentiel, la variation du champ magnétique sur l'axe de la spire est une fonction paire, c'est-à-dire une fonction symétrique par rapport à l'axe vertical du référentiel.

La figure 1a étend ce principe au cas de deux spires $S_1$, $S_2$ coaxiales selon un axe XX', placées à égale distance de part et d'autre d'un point O constituant le centre de la structure ainsi formée, et parcourues par des courants identiques en amplitude mais de sens opposés, comme l'indique le sens des flèches sur les deux spires de la figure 1a. Dans ce cas, on peut démontrer que l'ensemble des deux spires se comporte comme un quadripôle magnétique, avec une décroissance du champ magnétique en $1/x^4$ à distance de ce quadripôle. Sur la figure 2a, la courbe 1 représente la variation en amplitude du champ magnétique sur l'axe XX' passant par le centre O résultant de la spire $S_1$, alors que la courbe 2 représente la variation en amplitude du champ magnétique sur l'axe XX' passant par le centre O résultant de la spire $S_2$. La courbe 3 montre la résultante totale qui est la superposition des deux champs générés par les spires $S_1$ et $S_2$. Ainsi, on note que le champ magnétique sur l'axe des spires passant par le centre de la structure varie selon une fonction impaire, c'est-à-dire passant par le centre O et symétrique par rapport à ce centre O. La figure 2b représente également cette variation avec la courbe référencée 3.

Sur la figure 1b, une autre structure est constituée de quatre spires identiques, ou encore de deux groupes $G_1$, $G_2$ de quadripôles tels que celui représenté sur la figure 1 a. Les quatre spires sont coaxiales suivant l'axe XX', et les deux groupes de deux spires sont placés à égale distance de part et d'autre du centre O de la structure. En revanche, contrairement au cas illustré sur la figure 1a, deux spires prises dans chacun des groupes $G_1$, $G_2$, et placées à égale distance de part et d'autre du centre O, sont parcourues dans le même sens par le même courant, alors que deux spires d'un même groupe sont parcourues par des courants identiques en amplitude, mais de sens opposés. On peut montrer qu'une telle structure est équivalente à un octopôle magnétique, avec une décroissance du champ magnétique en $1/x^5$. En revanche, comme illustré par la courbe 4 sur la figure 2b, le champ magnétique sur l'axe XX' varie selon une fonction paire, c'est-à-dire présentant une symétrie par rapport à l'axe vertical du référentiel.

Sur la figure 1c, une troisième structure est représentée. Cette structure est constituée de huit spires identiques, ou encore de deux groupes $G'_1$, $G'_2$ d'octopôles tels que celui représenté sur la figure 1b. Les huit spires sont coaxiales suivant l'axe XX', et les deux groupes $G'_1$, $G'_2$ de quatre spires sont placés à égale distance de part et d'autre du centre O de la structure. Plus précisément, les groupes $G'_1$, $G'_2$ sont agencés de telle sorte que deux spires prises dans chacun des groupes, et placées à égale distance de part et d'autre du point O, sont parcourues par des courants identiques en amplitude mais de sens opposés comme l'indique le sens des flèches sur les spires de la figure 1c. Une telle structure est équivalente à un hexadécapôle magnétique, avec une décroissance du champ magnétique en $1/x^6$. Tout comme dans le cas du quadripôle, et comme illustré par la courbe 5 sur la figure 2b, le champ magnétique sur l'axe XX' induit par cette structure varie selon une fonction impaire, c'est-à-dire présentant une symétrie par rapport au centre O de la structure.

On peut généraliser ce qui précède de la façon suivante : Avec une structure constituée de deux groupes composés chacun de $2^{2n}$ spires identiques (n étant un entier supérieur ou égal à zéro), les deux groupes étant placés à égale distance de part et d'autre du centre O de la structure de sorte que deux spires prises dans chacun des groupes, et placées de façon symétrique par rapport au centre O de la structure, soient parcourues par des courants identiques en amplitude mais de sens opposés, on obtient une décroissance du champ magnétique en $1/x^{2(n+2)}$, et une variation du champ magnétique sur l'axe des spires selon une fonction impaire. Si n=0, on retrouve le quadripôle de la figure 1a avec une décroissance du champ magnétique en $1/x^4$. Avec n=1, on retrouve l'hexadécapôle de la figure 1c avec une décroissance du champ magnétique en $1/x^6$.

Au vu de ce qui précède, et notamment en regardant les courbes 3 à 5 de la figure 2b, on s'aperçoit qu'il est possible, avec les structures équivalentes à des multipôles magnétiques décrites précédemment, de confiner le champ magnétique du fait de la décroissance rapide du champ magnétique à l'extérieur des spires. Les principes précédents vont être ainsi appliqués pour réaliser le circuit primaire d'un capteur.

Plus précisément, un capteur inductif de mesure de courantsera tel que :

- d'une part, le circuit primaire comporte deux groupes comportant chacun $2^{2n}$ spires identiques et coaxiales selon un axe, n étant un entier supérieur ou égal à zéro, les deux groupes étant placés à égale distance de part et d'autre d'un point dudit axe constituant le centre du circuit primaire, de sorte que deux spires prises dans chacun des groupes, et placées de façon symétrique par rapport au centre, soient destinées à être parcourues par un courant de même intensité mais de sens opposé, correspondant au courant alternatif à mesurer, et
- d'autre part, le circuit secondaire comporte au moins deux bobines connectées en série, les deux bobines étant coaxiales et disposées le long dudit axe symétriquement par rapport au centre du circuit primaire de sorte que chacune des deux bobines se retrouve à l'intérieur de l'un des deux groupes, chaque bobine présentant des spires enroulées dans un sens opposé par rapport aux spires de l'autre bobine.

Grâce à la symétrie particulière utilisée pour le circuit primaire, mais aussi pour le circuit secondaire, on réalise un capteur de mesure de courant qui ne nécessite pas de blindage particulier, mais qui réalise la double fonction précitée de ce blindage.

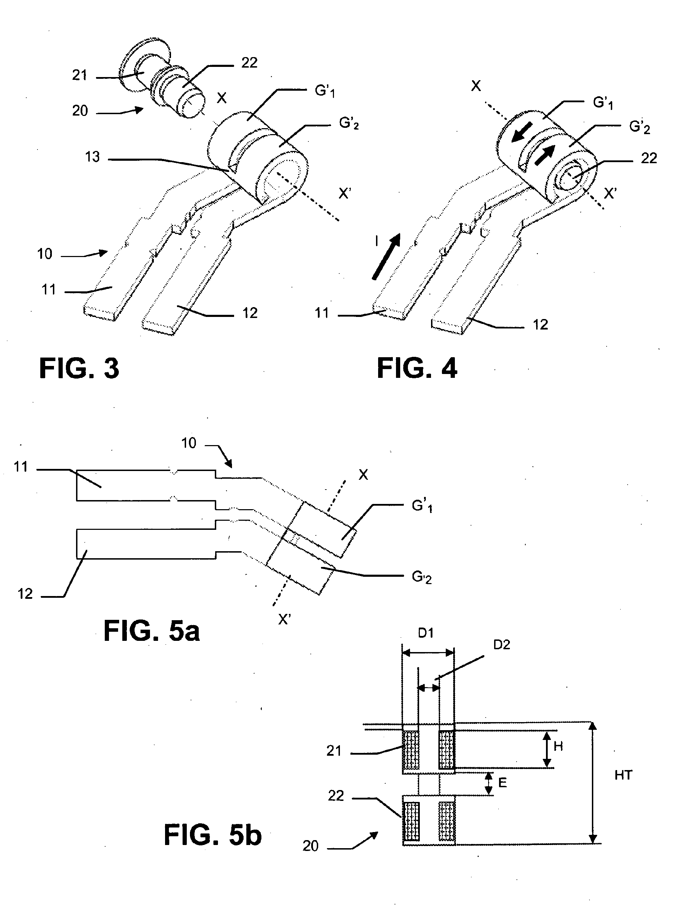

En référence aux figures 3 à 5, un premier capteur va maintenant être décrit. Ce capteur comporte essentiellement un circuit primaire 10 et un circuit secondaire 20 représentés séparément sur la figure 3, et assemblés sur la figure 4. Les figures 5a et 5b illustrent quant à elles le circuit primaire 10, respectivement le circuit secondaire 20, vus de dessus.

Le circuit primaire 10 est constitué avantageusement d'une pièce unique en matériau conducteur, par exemple en cuivre, comprenant deux extrémités 11, 12 constituant respectivement les bornes d'entrée et de sortie du capteur de mesure de courant, entre lesquelles va pouvoir circuler le courant alternatif I à mesurer. Ces bornes d'entrée et de sortie s'étendent de préférence parallèlement et sont contenues dans un même plan.

Entre ces deux extrémités 11, 12, la pièce présente une partie repliée selon une forme sensiblement cylindrique et creuse de façon à former deux groupes identiques $G'_1$, $G'_2$ d'une spire chacun, les spires étant coaxiales selon un axe XX' formant l'axe de révolution de la forme cylindrique, connectées en série entre les deux bornes d'entrée et de sortie grâce à une connexion 13 s'étendant parallèlement à l'axe XX', et formée ici intégralement dans la pièce. Si l'on considère le courant à mesurer rentrant par l'extrémité 11 et ressortant par l'extrémité 12, on comprend aisément que ce même courant va parcourir les spires identiques des deux groupes $G'_1$ et $G'_2$ dans des sens opposés, comme le montrent les flèches en trait épais de la figure 4. On se retrouve ici dans le cas particulier représenté schématiquement sur la figure 1a, le circuit primaire se comportant comme un quadripôle magnétique, avec une décroissance du champ magnétique en $1/x^4$, et une variation du champ magnétique dans l'axe XX' selon une fonction impaire par rapport au centre de l'arrangement des spires primaires.

La pièce constitutive du primaire présente par exemple les caractéristiques suivantes en termes de dimensions, en utilisant une plaque de cuivre d'épaisseur 2,2 mm:

- un diamètre interne de la forme cylindrique creuse de l'ordre de 11 mm;
- une longueur de cylindre de l'ordre de 20 mm constituée des deux bandes formant les spires de largeur 9,5 mm espacées d'environ 1 mm.

Ces dimensions sont compatibles avec un courant permanent dans le circuit primaire de 100 A efficace.

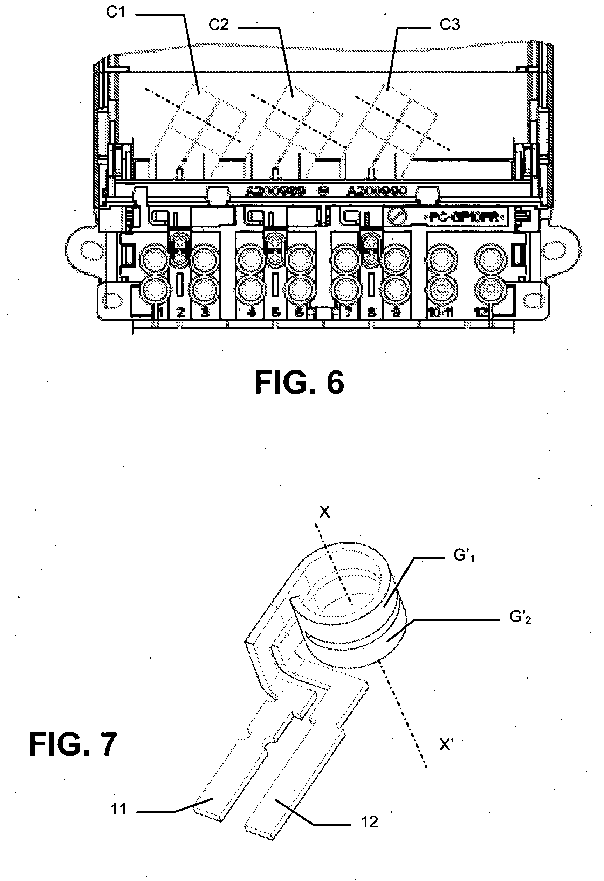

Comme on peut le constater sur les figures 3 à 5a, l'axe XX' est, dans ce mode particulier non limitatif de l'invention, choisi s'étendant dans un plan parallèle au plan contenant les bornes d'entrée 11 et de sortie 12. Cependant, il présente dans ce plan une inclinaison telle que sa projection dans le plan contenant les bornes 11 et 12 n'est pas perpendiculaire à la direction longitudinale des bornes. L'avantage lié à cette disposition particulière est visible sur la figure 6 représentant une vue de face partielle d'un compteur électrique triphasé équipé de trois capteurs C1, C2, C3 identiques à celui représenté sur la figure 4. Plus précisément, la figure 6 illustre la partie inférieure ou boîte à bornes d'un tel compteur munie de son cache borne. Ainsi, on constate que les axes des primaires (représentés en traits interrompus) pour les trois capteurs C1 à C3 sont parallèles mais non coaxiaux, ce qui réduit encore les possibles interférences magnétiques entre deux capteurs de phases différentes dans le cas d'un compteur triphasé.

D'autres dispositions sont néanmoins possibles pour obtenir ce même résultat. Ainsi, la figure 7 illustre le circuit primaire dans laquelle l'axe XX' de la forme cylindrique creuse est perpendiculaire au plan contenant les bornes d'entrées 11 et 12.

En référence à la figure 5b, le circuit secondaire 20 comporte quant à lui deux bobines multi spires identiques 21, 22 positionnées coaxialement sur l'axe XX' à l'intérieur de la forme creuse cylindrique (figure 4) de manière à se retrouver placées symétriquement par rapport au centre de cette forme.

Chacune des bobines 21 et 22 du circuit secondaire présente par exemple les caractéristiques dimensionnelles suivantes :

- longueur H de la bobine d'environ 6mm formée par un conducteur de diamètre 0,07 mm entouré autour d'un mandrin sur environ 84 tours par couche ;
- diamètre externe D1 de la bobine d'environ 7,7 mm ;
- diamètre interne D2 de la bobine d'environ 4 mm ;
- espacement E entre les deux bobines d'environ 2,5 mm pour une longueur totale HT du circuit secondaire de 17,5 mm.

De telles caractéristiques permettent d'obtenir un capteur dont la sensibilité est de l'ordre de 2 mV/A à 50 Hz.

- Chacune des bobines se retrouve donc placée à l'intérieur de l'un des groupes $G'_1$ et $G'_2$ du circuit primaire 10. Les deux bobines 21 et 22 sont en outre connectées en série, chaque bobine présentant des spires enroulées dans un sens opposé par rapport aux spires de l'autre bobine. Ainsi, comme l'induction magnétique sur l'axe du primaire est une fonction impaire, les deux bobines vont générer chacune une tension identique en amplitude mais opposée en phase. Les tensions induites par un champ magnétique alternatif externe et constant sur chacune des bobines vont ainsi s'annuler. En outre, les deux bobines 21, 22 sont avantageusement connectées, au niveau du centre du circuit primaire, à un même potentiel de référence. En effectuant la différence des tensions obtenues sur chacune des bobines, on double ainsi le signal utile, tout en éliminant les signaux de mode commun, à savoir les tensions dues au couplage électrostatique entre le circuit primaire et le circuit secondaire.

Ces tensions de mode commun sont particulièrement pénalisantes vis à vis de la précision du capteur à très faible courant primaire (10mA).

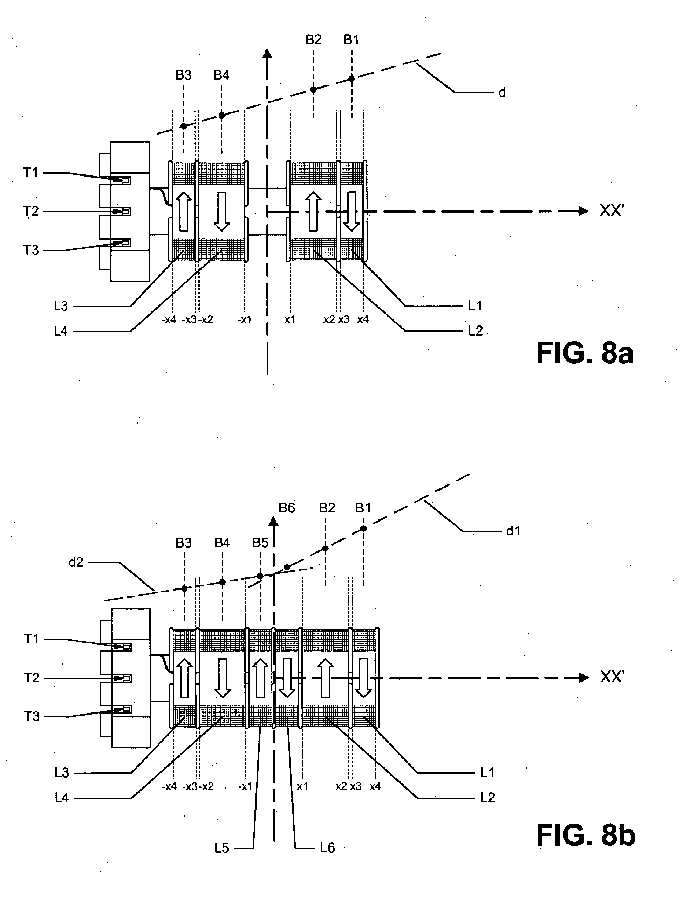

La structure du circuit secondaire peut être encore améliorée pour permettre également la suppression des composantes induites par un champ magnétique alternatif à gradient linéaire. La figure 8a illustre de manière schématique une structure de circuit secondaire permettant de supprimer les composantes d'un champ magnétique alternatif externe à gradient linéaire :

Pour ce faire, et comme schématisé sur la figure 8a, le circuit secondaire 20 est composé de deux groupements identiques de deux bobines multi spires L1 à L4, placés coaxialement selon l'axe XX', et symétriquement par rapport à un plan perpendiculaire à l'axe XX' et passant par le centre du circuit primaire 10.

Plus précisément, le premier groupement (à droite sur la figure) est constitué de deux bobines multi spires L1 et L2, et le deuxième groupement est constitué de deux bobines multi spires L3 et L4. Les bobines L1 et L3, correspondant aux bobines d'extrémités du circuit secondaire 20, sont identiques. De même, les bobines L2 et L4, correspondant aux bobines centrales dans le circuit secondaire, sont identiques. Deux bobines d'un même groupement sont connectées en série mais présentent des spires enroulées dans des sens opposés, comme indiqué par les différentes flèches à l'intérieur des différentes bobines. Le premier groupement possède une borne de sortie T1 et une borne de référence T2. Le second groupement possède une borne de sortie T3 et une borne de référence T2. Ainsi, les deux groupements de bobines sont avantageusement destinés à être connectés, au niveau du centre du primaire, à un même potentiel de référence de l'électronique métrologique sur la borne T2, cette borne correspond au point bas des deux bobines L2 et L4.

La sortie globale du circuit secondaire, correspondant à la différence entre les bornes de sorties T1 et T3 peut être exprimée par la relation suivante :

$$S = (S2 - S1) - (S4 - S3) \qquad (1)$$

relation dans laquelle Si correspond à la sortie de la bobine Li.

Pour illustrer le principe de la compensation, on a représenté sur la figure 8a les différentes abscisses selon l'axe XX' permettant de repérer la position des différentes bobines L1 à L4 par rapport à un référentiel passant par le centre de la structure. Ainsi :

- la bobine L1 est localisée entre les abscisses x3 et x4 ;
- la bobine L2 est localisée entre les abscisses x1 et x2 ;
- la bobine L3 est localisée entre les abscisses -x3 et -x4 ;
- la bobine L4 est localisée entre les abscisses -x1 et -x2.

En outre, on a représenté également une droite d correspondant à la variation en amplitude d'un champ magnétique alternatif externe à gradient linéaire sur l'axe XX'. Cette droite peut s'exprimer selon la relation :

$$B(x) \; = \; \frac{(B1 - B3)}{(x3 + x4)}x + \frac{(B1 + B3)}{2}$$

dans laquelle B1 et B3 correspondent aux amplitudes du champ magnétique alternatif externe vues au centre des bobines L1 et L3, c'est dire les deux bobines extérieures à l'arrangement des deux groupes secondaires.

Avec les paramètres précédents et en considérant la relation (1) ci-dessus donnant la sortie globale S du capteur, on peut démontrer que l'on obtient la relation suivante :

$$S=(G_{2,4}.(A.(x1+x2)/2+B)-G_{1,3}.(A.(x3+x4)/2+B))-(G_{2,4}.(A.(-x1-x2)/2+B)-$$

$$G_{1,3}.(A.(-x3-x4)/2+B))$$

Avec A = (B1-B3)/(x3+x4) et B = (B1+B3)/2

$G_{2,4}$ étant le gain des bobines L2 et L4, et $G_{1,3}$ étant le gain des bobines L1 et L3. Soit S = A.($G_{2,4}$.(x1+x2)- $G_{1,3}$.(x3+x4))

Le champ magnétique alternatif externe de gradient linéaire n'a pas d'influence si le rapport des gains entre les bobines L2, L4 et L1, L3 vérifie l'équation :

$$G_{2,4} / G_{1,3} = (x3+x4)/(x1+x2)$$

En d'autres termes, en déterminant correctement les gains des bobines d'un même groupement, ainsi que les positions des bobines sur l'axe, il est possible d'annuler l'effet d'un champ magnétique alternatif externe dont le gradient est linéaire sur toute la longueur du circuit secondaire, comme le montre la droite d sur la figure 8a.

On peut encore améliorer ce principe en augmentant le nombre de bobines constituant chaque groupement du circuit secondaire. La figure 8b illustre un second exemple dans lequel le circuit secondaire est constitué de deux groupements identiques comportant chacun trois bobines multi-spires, les deux groupements étant agencés à égale distance de part et d'autre du centre de la structure, et connectés en série. Le point milieu des deux groupements est en outre avantageusement relié à un même potentiel de référence, de façon à rendre possible un traitement différentiel permettant d'éliminer, comme expliqué précédemment, les tensions de mode commun.

On retrouve sur la figure 8b les quatre bobines L1 à L4 du circuit secondaire de la figure 8a, auxquelles on a ajouté deux bobines L5 et L6 entre les abscisses -x1 et x1.

Dans ce cas, la sortie globale du circuit secondaire, correspondant à la différence entre les bornes de sorties T1 et T3 peut être exprimée par la relation suivante :

$$S = (S2 - S1 - S6) - (S4 - S3 - S5) \qquad (2)$$

relation dans laquelle Si correspond à la sortie de la bobine Li.

Avec une telle structure, il est possible de supprimer l'influence d'un champ magnétique alternatif externe variant selon deux gradients linéaires, comme illustré par les deux droites d1 et d2 de la figure 8b. Pour ce faire, le gain $G_{2,4}$ des bobines L2 et L4 doit être le double des gains $G_{1,3}$ et $G_{5,6}$ des bobines L1, L3 et L5, L6.

De cette manière, le groupement des bobines L1, L2 et L6 à droite sur la figure 8b va annuler les contributions du champ magnétique alternatif externe dont l'amplitude varie selon la droite d1, alors que le groupement des bobines L3, L4 et L5 à gauche sur la figure 8b va annuler les contributions du champ magnétique alternatif externe dont l'amplitude varie selon la droite d2.

Ainsi, en déterminant correctement les gains des bobines d'un même groupement, ainsi que les positions des bobines sur l'axe, la structure de circuit secondaire selon la figure 8b permet d'annuler l'effet d'un champ magnétique alternatif externe dont le gradient est linéaire sur une longueur correspondant à chaque groupement du circuit secondaire.

Le principe du circuit secondaire de la figure 8b peut être généralisé à tout circuit secondaire comportant deux groupements identiques comportant chacun au moins un sous-groupement de trois bobines multi spires coaxiales disposées le long dudit axe, Les deux groupements doivent être disposés symétriquement par rapport au centre et connectés en série. Par ailleurs, les trois bobines d'un même sous-groupement sont connectées en série mais présentent des spires enroulées dans des sens opposés. Avec une telle structure, les gains et les positions selon l'axe des bobines d'un même sous-groupement peuvent être ajustés pour compenser l'influence d'un champ magnétique alternatif externe à gradient linéaire sur une longueur correspondant à la longueur de chaque sous-groupement du circuit secondaire. Enfin, comme dans les cas précédents, les deux groupements présentent de préférence un point milieu, au niveau du centre du circuit primaire, connecté à un même potentiel de référence, de façon à autoriser un traitement différentiel, et éliminer ainsi les tensions de mode commun.

Le capteur qui vient d'être décrit est particulièrement adapté pour la mesure de courants de forte amplitude (typiquement entre 10 mA à 100A). Ces capteurs sont utilisés sur des compteurs d'électricité placés sur des réseaux basse tension pour lesquels les phases du réseau traversent les compteurs.

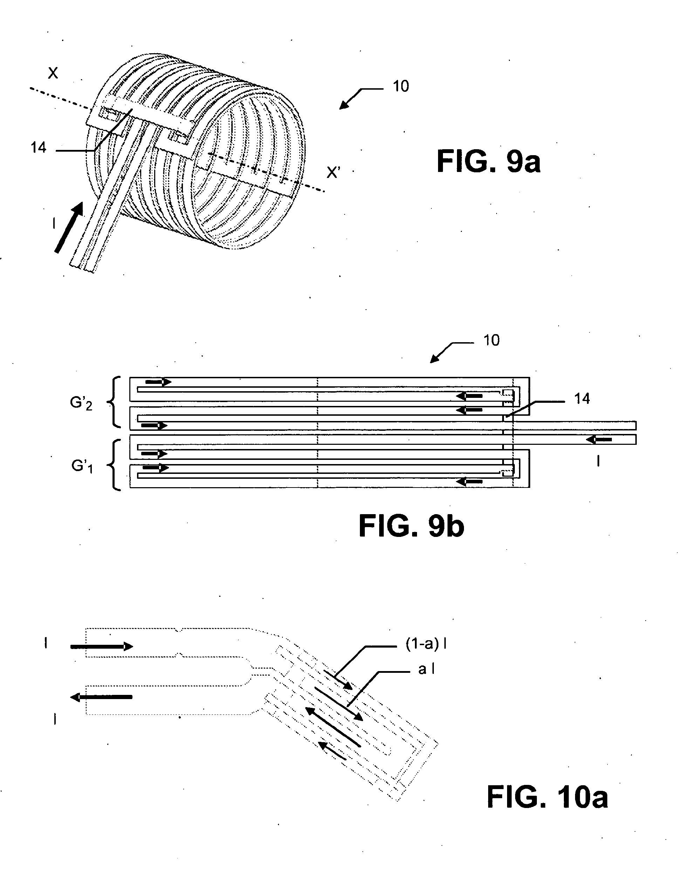

On va maintenant décrire, en référence aux figures 9a et 9b le circuit primaire d'un deuxième capteur plus particulièrement adapté à la mesure de courant de faible amplitude (typiquement entre 1 mA à 10A). Ces capteurs sont utilisés sur des compteurs d'électricité placés sur des réseaux basse tension de forte puissance ou haute tension, réseau pour lesquels les capteurs de courants sont reliés à des transformateurs de courant abaisseurs.

Le circuit primaire 10 représenté sur les figures 9a et 9b répond très exactement au schéma de principe représenté sur la figure 1c. Ce circuit primaire est avantageusement obtenu à partir d'une plaque en matériau électriquement conducteur, par exemple en cuivre, découpée en lamelles identiques et parallèles selon le motif visible sur la figure 9b. La plaque est ensuite enroulée pour former le cylindre creux d'axe XX' de la figure 8a, à l'intérieur duquel doit être placé le circuit secondaire. On retrouve ainsi les deux groupes $G'_1$ et $G'_2$ de quatre spires chacun. Toutes les spires sont connectées en série, de sorte qu'elles sont toutes destinées à être parcourues par le courant alternatif 1 à mesurer. Le parcours de ce courant a été schématisé par des flèches en trait épais sur le circuit primaire développé de la figure 9b. Une fois la plaque repliée, on obtient très exactement le sens de parcours du courant dans les différentes spires indiqués sur la figure 1c. A noter que la découpe de la plaque comporte une pièce rapportée 14 formant pont électrique destinée à relier en série les deux spires situées en avant dernière position. L'enroulement de la plaque permet en outre l'obtention d'un circuit primaire multi-couches, ce qui présente l'avantage d'augmenter la sensibilité du capteur destiné à la mesure de courants de faible amplitude.

Le circuit primaire 10 qui vient d'être décrit peut être associé à un circuit secondaire 20 à deux bobines multi spires similaire à celui décrit précédemment en référence à la figure 5b, ou à un circuit secondaire à quatre bobines ou plus, du type de celui décrit en référence à la figure 8.

Dans les différentes structures de circuits primaires décrites ci-dessus, on a vu que le courant de même intensité parcourant les différentes spires du circuit primaire correspond au courant alternatif à mesurer. En d'autres termes, les différentes spires sont connectées en série entre la borne de connexion d'entrée et la borne de connexion de sortie du circuit primaire.

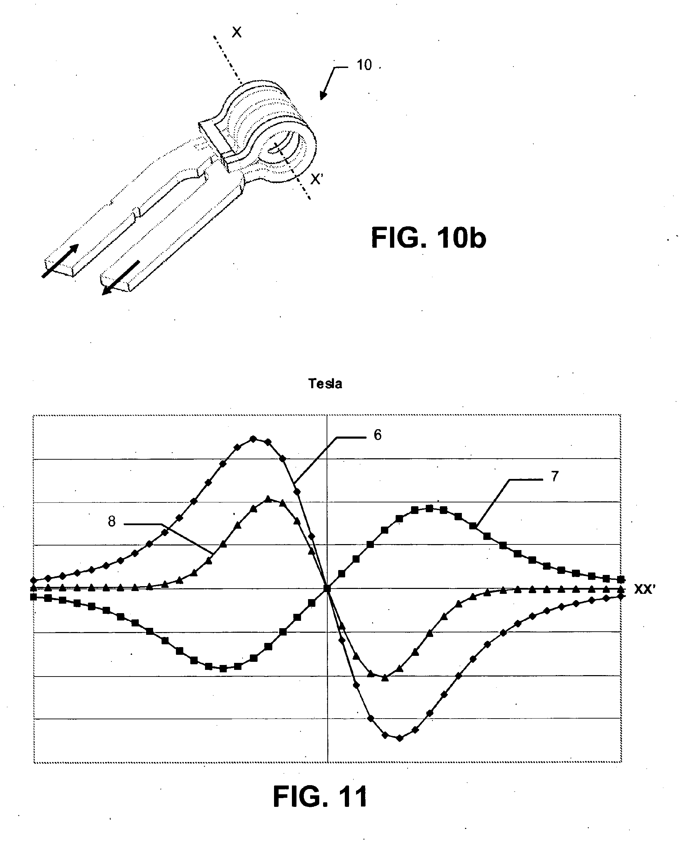

Un circuit primaire selon un mode de réalisation conforme à l'invention va à présent être décrit en référence aux figures 10a, 10b et 11. Ici, le circuit primaire est constitué de deux groupes comportant chacun deux spires coaxiales selon l'axe XX'. Les deux groupes sont situés à égale distance de part et d'autre du centre du circuit primaire, et deux spires prises dans chacun des groupes et situées de façon symétrique par rapport à ce centre, sont destinées à être parcourues par un courant de même intensité, mais de sens opposé. C'est cette géométrie particulière qui permet, comme on l'a vu précédemment, d'obtenir un champ magnétique induit sur l'axe XX' variant selon une fonction impaire. En revanche, la particularité de ce circuit primaire selon le mode de réalisation réside dans le fait que les deux spires d'un même groupe ne sont pas parcourues par le courant alternatif à mesurer, mais seulement par une portion de ce courant, complémentaire de la portion de courant passant dans l'autre spire.

Ainsi, si I représente l'amplitude du courant alternatif à mesurer, l'une des spires d'un groupe sera parcourue par un courant d'amplitude égale à aI (a étant un nombre inférieur à 1), alors que l'autre spire sera parcourue par un courant d'amplitude (1-a)I. Le circuit primaire représenté en vue développée sur la figure 10a est tel que les deux spires d'un même groupe ont une même épaisseur et un rapport de cotes en largeur de a/(1-a), ce qui permet d'obtenir une répartition des courants dans chacune des spires proportionnelle à leur largeur respective (a.l et (1-a).l). La réalisation mécanique consiste à replier sur une matrice cylindrique chacun des deux circuits en des sens opposés, ce qui permet de constituer deux groupes de deux spires avec des circulations de courants différents et de sens opposés.

Les variations du champ magnétique induit par un tel circuit primaire sont représentées sur la figure 11. Plus précisément :

- la courbe 6 illustre la variation selon l'axe XX' du champ magnétique induit par les deux spires centrales du circuit, parcourues par un courant d'amplitude al ;
- la courbe 7 illustre la variation selon l'axe XX' du champ magnétique induit par les deux spires d'extrémité du circuit, parcourues par un courant d'amplitude (1-a)l ;
- la courbe 8 illustre la variation selon l'axe XX' du champ magnétique total induit par le circuit primaire dans son ensemble et qui est la superposition des deux champs des courbes 6 et 7

Grâce à cette structure particulière, on obtient une concentration optimale des lignes de champ magnétique à l'intérieur du circuit primaire.

Comme dans le cas des structures précédentes, on pourra associer à ce circuit primaire :

- soit un circuit secondaire à deux bobines multi spires, du type de celui décrit en référence à la figure 5b.
- soit un circuit secondaire du type de celui décrit en référence aux figures 8a et 8b pour augmenter l'immunité au champ magnétique alternatif externe à gradient linéaire.

Par ailleurs, toutes les variantes précédemment décrites de réalisation du circuit primaire utilisent un conducteur unique (plaque repliée). On pourrait bien entendu remplacer ce conducteur unique par un ensemble de spires bobinées en utilisant un fil isolé de faible section adapté pour des courants de faible intensité.

En outre, sur les différentes figures, les spires des circuits primaires et secondaires ont une forme circulaire. Bien entendu, les différents principes de l'invention sont applicables à d'autres formes de spires (rectangulaires, carrées...).

## Revendications

1.  Capteur inductif de mesure de courant du type comportant un circuit primaire (10) destiné à être parcouru par un courant alternatif (I) à mesurer, et un circuit secondaire (20) couplé magnétiquement dans l'air au circuit primaire, ledit circuit primaire (10) comprenant deux groupes ($G'_1$, $G'_2$) comportant chacun $2^p$ spires coaxiales selon un axe (XX'), p étant un entier supérieur ou égal à zéro, les deux groupes étant placés à égale distance de part et d'autre d'un point dudit axe constituant le centre (0) du circuit primaire (10), de sorte que deux spires prises dans chacun des groupes ($G'_1$, $G'_2$), et placées de façon symétrique par rapport au centre (0) du circuit primaire soient destinées à être parcourues par un courant de même intensité mais de sens opposé, correspondant au courant alternatif (I) à mesurer ou à une portion du courant alternatif (I) à mesurer, et le circuit secondaire (20) comportant au moins deux bobines multi spires connectées en série, les deux bobines étant coaxiales et disposées le long dudit axe (XX') symétriquement par rapport audit centre (0) de sorte que chacune des deux bobines se retrouve à l'intérieur de l'un des deux groupes ($G'_1$, $G'_2$), chaque bobine possédant des spires enroulées dans un sens opposé par rapport aux spires de l'autre bobine , **caractérisé en ce que** chacun des deux groupes (G'1, G'2) du circuit primaire comporte deux spires coaxiales selon ledit axe (XX'), chacune des deux spires étant destinée à être parcourue par une portion du courant alternatif (I) à mesurer complémentaire de la portion du courant alternatif dans l'autre spire.

2.  Capteur inductif selon la revendication 1, **caractérisé en ce que** le circuit primaire (10) est formé d'une pièce unique en matériau électriquement conducteur, comprenant deux extrémités formant respectivement les bornes d'entrée et de sortie du circuit primaire, ainsi qu'une partie entre les deux extrémités repliée selon un forme sensiblement cylindrique et creuse dont l'axe de révolution définit ledit axe (XX').

3.  Capteur inductif selon la revendication 2, **caractérisé en ce que** l'axe (XX') s'étend dans un plan parallèle au plan contenant les bornes d'entrée et de sortie, avec une inclinaison telle que sa projection dans le plan contenant les bornes d'entrée et de sortie n'est pas perpendiculaire à la direction longitudinale des bornes.

4.  Capteur inductif selon l'une quelconque des revendications précédentes, **caractérisé en ce que** les deux bobines du circuit secondaire (20) sont connectées, au niveau du centre du circuit primaire (10), à un même potentiel de référence.

**5.** Capteur inductif selon l'une quelconque des revendications 1 à 3, **caractérisé en ce que** le circuit secondaire (20) comporte deux groupements identiques comportant chacun deux bobines multi spires (L1, L2 ; L3, L4) coaxiales disposées le long dudit axe (XX'), les deux groupements étant disposés symétriquement par rapport audit centre (0) et connectés en série, les deux bobines d'un même groupement étant connectées en série mais présentant des spires enroulées dans des sens opposés, les gains et les positions selon l'axe des bobines d'un même groupement étant déterminés pour compenser l'influence d'un champ magnétique alternatif externe à gradient linéaire sur toute la longueur du circuit secondaire.

**6.** Capteur inductif selon l'une quelconque des revendications 1 à 4, **caractérisé en ce que** le circuit secondaire (20) comporte deux groupements identiques comportant chacun trois bobines multi spires (L1-L3 ; L4-L6) coaxiales disposées le long dudit axe (XX'), les deux groupements étant disposés symétriquement par rapport audit centre (0) et connectés en série, les trois bobines d'un même groupement étant connectées en série mais présentant des spires enroulées dans des sens opposés, les gains et les positions selon l'axe des bobines d'un même groupement étant déterminés pour compenser l'influence d'un champ magnétique alternatif externe à gradient linéaire sur une longueur correspondant à la longueur de chaque groupement du circuit secondaire.

**7.** Capteur inductif selon l'une quelconque des revendications 1 à 4, **caractérisé en ce que** le circuit secondaire comporte deux groupements identiques comportant chacun au moins un sous-groupement de trois bobines multi spires coaxiales disposées le long dudit axe (XX'), les deux groupements étant disposés symétriquement par rapport audit centre (0) et connectés en série, les trois bobines d'un même sous-groupement étant connectées en série mais présentant des spires enroulées dans des sens opposés, les gains et les positions selon l'axe des bobines d'un même sous-groupement étant déterminés pour compenser l'influence d'un champ magnétique alternatif externe à gradient linéaire sur une longueur correspondant à la longueur de chaque sous-groupement du circuit secondaire.

**8.** Capteur inductif selon l'une quelconque des revendications 6 et 7, **caractérisé en ce que** les trois bobines d'un même groupement ou sous-groupement sont telles que le gain de la bobine centrale d'un même groupement ou sous-groupement corresponde au double du gain des deux autres bobines.

**9.** Capteur inductif selon l'une quelconque des revendications 5 à 8, **caractérisé en ce que** les deux groupements du circuit secondaire (20) sont connectés, au niveau du centre du circuit primaire (10), à un même potentiel de référence.

**Claims**

**1.** An inductive current sensor, of the kind comprising a primary circuit (10) to be traversed by an alternating current (I) to be measured, and a secondary circuit (20) magnetically coupled in air to the primary circuit, said primary circuit (10) comprising two sets ($G'_1$, $G'_2$) each comprising $2^p$ turns coaxial with an axis (XX'), p being an integer greater than or equal to zero, with both sets being placed at the same distance on either side of a point of said axis composing the center (0) of the primary circuit (10), so that two turns taken from each of the sets ($G'_1$, $G'_2$) and placed symmetrically with respect to the center (0) of the primary circuit are meant to be traversed by a current of the same intensity but in the opposite direction, corresponding to the alternating current (I) to be measured or to a portion of the alternating current (I) to be measured, and the secondary circuit (20) comprising at least two series-connected multiple turn coils, with both coils being coaxial and arranged along said axis (XX') symmetrically with respect to the center (0) so that each of the two coils can be found within one of both sets ($G'_1$, $G'_2$), with each coil having turns wound up in an opposite direction with respect to the turns of the other coil, **characterized in that** each of the two sets ($G'_1$, $G'_2$) of the primary circuit comprises two turns coaxial with said axis (XX'), each of both turns to be traversed by a portion of the alternating current (I) to be measured, which is complementary to the portion of the alternating current in the other turn.

**2.** The inductive sensor according to claim 1, **characterized in that** the primary circuit (10) is formed of a single part of an electrically conductive material, comprising two ends respectively forming the input and output terminals of the primary circuit, as well as a part between both ends folded back in a substantially cylindrical and hollow shape the rotational axis of which defines said axis (XX').

**3.** The inductive sensor according to claim 2, **characterized in that** the axis (XX') extends in a plane parallel to the plane containing the input and output terminals, having an inclination such that the projection thereof in the plane containing the input and output terminals is not perpendicular to the longitudinal direction of the terminals.

4. The inductive sensor according to any of the preceding claims, **characterized in that** both coils of the secondary circuit (20) are connected, at the center of the primary circuit (10) to one and the same reference potential.

5. The inductive sensor according to any of claims 1 to 3, **characterized in that** the secondary circuit (20) comprises two identical arrays, each comprising two coaxial multiple turn coils (L1, L2; L3, L4) arranged along said axis (XX'), with both arrays being arranged symmetrically with respect to the center (0) and connected in series, with both coils of a same array being connected in series, but having turns wound up in opposite directions, with the gains and positions along the axis of the coils of a same array being determined in order to compensate the influence of an external alternating magnetic field having a linear gradient over the whole length of the secondary circuit.

6. The inductive sensor according to any of claims 1 to 4, **characterized in that** the secondary circuit (20) comprises two identical arrays each comprising three coaxial multiple turn coils (L1-L3; L4-L6) arranged along said axis (XX'), with both arrays being arranged symmetrically with respect to said center (0) and connected in series, with the three coils of a same array being connected in series, but having turns wound up in opposite directions, with the gains and positions along the axis of the coils of a same array being determined in order to compensate the influence of an external alternating magnetic field having a linear gradient over a length corresponding to the length of each array of the secondary circuit.

7. The inductive sensor according to any of claims 1 to 4, **characterized in that** the secondary circuit comprises two identical arrays, each comprising at least one sub-array of three coaxial multiple turn coils arranged along said axis (XX'), with both arrays being arranged symmetrically with respect to said center (0) and connected in series, with the three coils of a same sub-array being connected in series, but having turns wound up in opposite directions, with the gains and positions along the axis of the coils of a same sub-array being determined in order to compensate the influence of an external alternating magnetic field having a linear gradient over a length corresponding to the length of each sub-array of the secondary circuit.

8. The inductive sensor according to any of claims 6 and 7, **characterized in that** the three coils of a same array or sub-array are such that the gain of the center coil of a same array or sub-array corresponds to twice the gain of the two other coils.

9. The inductive sensor according to any of claims 5 to 8, **characterized in that** both arrays of the secondary circuit (20) are connected, at the center of the primary circuit (10), to one and the same reference potential.

**Patentansprüche**

1. Induktiver Stromsensor, von der Art umfassend einen Primärkreis (10), der dazu gedacht ist, von einem zu messenden Wechselstrom (I) durchflossen zu werden, und einen Sekundärkreis (20), der magnetisch in Luft mit dem Primärkreis gekoppelt ist, wobei der Primärkreis (10) zwei Gruppen ($G'_1$, $G'_2$) umfasst, die jeweils $2^p$ Windungen umfassen, die entlang einer Achse (XX') koaxial sind, wobei p eine Ganzzahl größer oder gleich Null ist, wobei die beiden Gruppen im gleichen Abstand auf beiden Seiten eines Punktes der Achse angeordnet sind, der den Mittelpunkt (0) des Primärkreises (10) bildet, so dass zwei Windungen, die aus jeder der Gruppen ($G'_1$, $G'_2$) genommen werden und zu dem Mittelpunkt (0) des Primärkreises symmetrisch angeordnet sind, dazu gedacht sind, von einem gleichstarken jedoch gegensinnigen Strom durchflossen zu werden, der dem zu messenden Wechselstrom (I) oder einem Teil des zu messenden Wechselstroms (I) entspricht, und wobei der Sekundärkreis (20) mindestens zwei in Reihe geschaltete Spulen mit mehreren Windungen umfasst, wobei die Spulen koaxial sind und an der Achse (XX') entlang symmetrisch zum Mittelpunkt (0) angeordnet sind, so dass jede der beiden Spulen sich in einer der beiden Gruppen ($G'_1$, $G'_2$) befindet, wobei jede Spule Windungen besitzt, die in einer zu den Windungen der anderen Spule entgegengesetzten Richtung aufgewickelt sind, **dadurch gekennzeichnet, dass** jede der beiden Gruppen ($G'_1$, $G'_2$) des Primärkreises zwei Windungen umfasst, die der Achse (XX') nach koaxial sind, wobei jede der beiden Windungen dazu gedacht ist, von einem Teil des zu messenden Wechselstroms (I) durchflossen zu werden, der zu dem Teil des Wechselstroms in der anderen Windung komplementär ist.

2. Induktiver Sensor nach Anspruch 1, **dadurch gekennzeichnet, dass** der Primärkreis (10) aus einem einzelnen Stück eines elektrisch leitfähigen Materials gebildet wird, das zwei Enden umfasst, die jeweils die Ein- und Ausgangsklemmen des Primärkreises bilden, sowie einen Teil zwischen den beiden Enden, der in einer im Wesentlichen zylindrischen und hohlen Form umgebogen ist, deren Drehachse die Achse (XX') definiert.

**3.** Induktiver Sensor nach Anspruch 2, **dadurch gekennzeichnet, dass** die Achse (XX') sich in einer Ebene erstreckt, die zu der Ebene parallel ist, welche die Ein- und Ausgangsklemmen enthält, mit einer derartigen Neigung, dass ihre Projektion in der Ebene, welche die Ein- und Ausgangsklemmen enthält, zu der Längsrichtung der Klemmen nicht rechtwinklig ist.

**4.** Induktiver Sensor nach einem der vorhergehenden Ansprüche, **dadurch gekennzeichnet, dass** die beiden Spulen des Sekundärkreises (20) am Mittelpunkt des Primärkreises (10) an ein und dasselbe Bezugspotential angeschlossen sind.

**5.** Induktiver Sensor nach einem der Ansprüche 1 bis 3, **dadurch gekennzeichnet, dass** der Sekundärkreis (20) zwei identische Gruppierungen umfasst, die jeweils zwei koaxiale Spulen mit mehreren Windungen (L1, L2; L3, L4) umfassen, die an der Achse (XX') entlang angeordnet sind, wobei die beiden Gruppierungen im Verhältnis zum Mittelpunkt (0) symmetrisch angeordnet und in Reihe geschaltet sind, wobei die beiden Spulen einer selben Gruppierung in Reihe geschaltet sind, jedoch Windungen aufweisen, die in entgegengesetzten Richtungen aufgewickelt sind, wobei die Verstärkungen und Positionen gemäß der Achse der Spulen einer selben Gruppierung bestimmt werden, um den Einfluss eines externen magnetischen Wechselfeldes mit einem linearen Gradienten über die gesamte Länge des Sekundärkreises hinweg auszugleichen.

**6.** Induktiver Sensor nach einem der Ansprüche 1 bis 4, **dadurch gekennzeichnet, dass** der Sekundärkreis (20) zwei identische Gruppierungen umfasst, die jeweils drei koaxiale Spulen mit mehreren Windungen (L1-L3; L4-L6) umfassen, die an der Achse (XX') entlang angeordnet sind, wobei die beiden Gruppierungen im Verhältnis zum Mittelpunkt (0) symmetrisch angeordnet und in Reihe geschaltet sind, wobei die drei Spulen einer selben Gruppierung in Reihe geschaltet sind, jedoch Windungen aufweisen, die in entgegengesetzten Richtungen aufgewickelt sind, wobei die Verstärkungen und Positionen gemäß der Achse der Spulen einer selben Gruppierung bestimmt werden, um den Einfluss eines externen magnetischen Wechselfeldes über eine Länge, die der Länge jeder Gruppierung des Sekundärkreises entspricht, auszugleichen.

**7.** Induktiver Sensor nach einem der Ansprüche 1 bis 4, **dadurch gekennzeichnet, dass** der Sekundärkreis zwei identische Gruppierungen umfasst, die jeweils mindestens eine Untergruppierung aus drei koaxialen Spulen mit mehreren Windungen umfassen, die an der Achse (XX') entlang angeordnet sind, wobei die beiden Gruppierungen im Verhältnis zum Mittelpunkt (O) symmetrisch angeordnet und in Reihe geschaltet sind, wobei die drei Spulen einer selben Untergruppierung in Reihe geschaltet sind, jedoch Windungen aufweisen, die in entgegengesetzten Richtungen aufgewickelt sind, wobei die Verstärkungen und Positionen gemäß der Achse der Spulen einer selben Untergruppierung bestimmt werden, um den Einfluss eines externen magnetischen Wechselfeldes mit einem linearen Gradienten über eine Länge, die der Länge jeder Untergruppierung des Sekundärkreises entspricht, auszugleichen.

**8.** Induktiver Sensor nach einem der Ansprüche 6 und 7, **dadurch gekennzeichnet, dass** die drei Spulen einer selben Gruppierung oder Untergruppierung derart ausgestaltet sind, dass die Verstärkung der mittleren Spule einer selben Gruppierung oder Untergruppierung der zweifachen Verstärkung der anderen beiden Spulen entspricht.

**9.** Induktiver Sensor nach einem der Ansprüche 5 bis 8, **dadurch gekennzeichnet, dass** die beiden Gruppierungen des Sekundärkreises (20) am Mittelpunkt des Primärkreises (10) an ein und dasselbe Bezugspotential angeschlossen sind.

FIG. 1a

FIG. 1b

FIG. 1c

Tesla

FIG. 2a

Tesla

FIG. 2b

**FIG. 3**

**FIG. 4**

**FIG. 5a**

**FIG. 5b**

C1   C2   C3

**FIG. 6**

X

G'₁

G'₂

X'

**FIG. 7**

11

12

FIG. 8a

FIG. 8b

X

14

I

10

**FIG. 9a**

10

G'₂

G'₁

14

I

**FIG. 9b**

I

I

(1-a) I

a I

**FIG. 10a**

**FIG. 10b**

**FIG. 11**

## RÉFÉRENCES CITÉES DANS LA DESCRIPTION

**Documents brevets cités dans la description**

- FR 2803914
- EP 1515146 A